# EUROPEAN PATENT APPLICATION

(11) **EP 4 650 800 A1**
(43) Date of publication of application: **19.11.2025**
(21) Application number: 24920583.2
(22) Date of filing: 06.12.2024
(51) Int. Cl.: G01R 31/382, G01R 31/396, G01R 19/165, G01R 19/10, G01R 19/12

(54) **BATTERY FAULT DIAGNOSIS APPARATUS AND METHOD FOR DETERMINING FDC VALUE BY APPLYING WEIGHT**

(30) Priority: 25.01.2024 KR 20240011465
(71) Applicant: LG Energy Solution, Ltd., Seoul 07335 (KR)
(72) Inventor: CHOI, Hodeuk, Daejeon 34122 (KR)
(74) Representative: Goddar, Heinz J.
(86) International application number: PCT/KR2024/019977
(87) International publication number: WO 2025/159333

(57) **Abstract**

The present invention relates to a battery fault diagnosing device and a method of determining a fault detection counter (FDC) value by applying a weighting, and the battery fault diagnosing device of the present invention may include a measuring unit that generates measurement data on the cell voltage of each of a plurality of battery cells included in the battery pack, an FDC determining unit that increases an FDC value with an increase inclination or decreases the FDC value with a decrease inclination on the basis of the result of comparison between the measurement data and a predetermined threshold voltage value, a weighting determining unit that determines a target weighting to be applied to the increase inclination or the decrease inclination, on the basis of the FDC value at the time of applying the increase inclination or the decrease inclination and the magnitude of a voltage deviation obtained by subtracting the threshold voltage value from the measurement data, and a DTC setting unit that sets a diagnostic trouble code (DTC) value corresponding to the FDC value to a first value indicating that the battery pack is abnormal, when the FDC value reaches a predetermined upper limit threshold, and sets the DTC value corresponding to the FDC value to a second value indicating that the battery pack is normal, when the FDC value reaches a predetermined lower limit threshold.

## Description

### [Technical Field]

### CROSS-REFERENCE TO RELATED APPLICATION(S)

This application claims priority to and the benefit of Korean Patent Application No. 10-2024-0011465 filed in the Korean Intellectual Property Office on January 25, 2024, the entire contents of which are incorporated herein by reference.

The present disclosure relates to a battery fault diagnosing device and a method of determining a fault detection counter (FDC) value.

### [Background Art]

According to the ISO-14229 standard protocol definition, in the case of fault detection counter (FDC) read for determining a diagnostic trouble code (DTC), an FDC tends to operate to regularly increase or decrease by a predefined step-up or step-down size depending on a test period during diagnosis enabling or diagnosis disabling in a range between 0x80 and 0x7F according to determined diagnosis.

However, in order for 0x7F to be reached from the FDC value of 0 indicating that a diagnostic target is normal using only the determined step-up or step-down size such that a diagnosis enabling condition is satisfied, step-up should be repeated a large number of times. Also, in order for 0x80 to be reached from the normal condition using only the determined step-up or step-down size such that a diagnosis disabling condition is satisfied, step-down should be repeated a large number of times. Accordingly, there is a problem that the waiting time for the diagnosis enabling condition or the diagnosis disabling condition to be satisfied may lengthen.

Recently, in order to diagnose a battery for checking a thermal event or an isolation event, it is required to quickly cope with a battery fault.

### [Disclosure]

### [Technical Problem]

The present disclosure attempts to provide a battery fault diagnosing device and a method of determining a fault detection counter (FDC) value by applying a weighting.

### [Technical Solution]

A battery fault diagnosis device according to a feature of the invention is a device for diagnosing a fault of a battery by generating fault detection counter (FDC) information from a lower limit threshold to an upper limit threshold for the battery, and may include a measuring unit that is connected to a battery pack and generates measurement data on the cell voltage of each of a plurality of battery cells included in the battery pack, an FDC determining unit that increases an FDC value with an increase inclination or decreases the FDC value with a decrease inclination on the basis of the result of comparison between the measurement data and a predetermined threshold voltage value, a weighting determining unit that determines a target weighting to be applied to the increase inclination or the decrease inclination, on the basis of the FDC value at the time of applying the increase inclination or the decrease inclination and the magnitude of a voltage deviation obtained by subtracting the threshold voltage value from the measurement data, and a DTC setting unit that sets a diagnostic trouble code (DTC) value corresponding to the FDC value to a first value indicating that the battery pack is abnormal, when the FDC value reaches a predetermined upper limit threshold, and sets the DTC value corresponding to the FDC value to a second value indicating that the battery pack is normal, when the FDC value reaches a predetermined lower limit threshold.

When the voltage deviation exceeds 0, the FDC determining unit may select the increase inclination from the increase inclination and the decrease inclination, and determine a value obtained by applying a first target weighting determined by the weighting determining unit to a predetermined increase reference inclination stored in advance, as the increase inclination, and when the voltage deviation is smaller than 0, the FDC determining unit may select the decrease inclination from the increase inclination and the decrease inclination, and determine a value obtained by applying a second target weighting determined by the weighting determining unit to a predetermined decrease reference inclination stored in advance, as the decrease inclination.

When the FDC value at the time of applying is equal to or smaller than the lower limit value of a predetermined weighting application range between the upper limit threshold and the lower limit threshold, or equal to or larger than the upper limit value of the weighting application range, the weighting determining unit may determine the target weighting as 1.

When the FDC value at the time of applying is within a predetermined weighting application range between the upper limit threshold and the lower limit threshold, the weighting determining unit may determine one of a plurality of reference weightings as the target weighting, depending on the magnitude of the voltage deviation, and the greater the ratio of the voltage deviation to the threshold voltage value is, the larger the values of the plurality of reference weightings may be.

When the FDC value at the time of applying is within a predetermined weighting application range between the upper limit threshold and the lower limit threshold, the voltage deviation exceeds 0, and the ratio of the voltage deviation to the threshold voltage value exceeds a predetermined upper limit increase deviation, the FDC determining unit may determine the FDC value as the upper limit value of the weighting application range.

When the FDC value at the time of applying is within a predetermined weighting application range between the upper limit threshold and the lower limit threshold, the voltage deviation is smaller than 0, and the ratio of the voltage deviation to the threshold voltage value exceeds a predetermined upper limit decrease deviation, the FDC determining unit may determine the FDC value as the lower limit value of the weighting application range.

A method of determining an FDC value by applying a weighting according to another feature of the invention is a method by which a device for diagnosing a fault of a battery by generating fault detection counter (FDC) information from a lower limit threshold to an upper limit threshold for the battery determines an FDC value by applying weights, and may include a step of generating measurement data indicating the cell voltage of each of a plurality of battery cells included in a battery pack, a step of determining a target weighting to be applied to an increase inclination or a decrease inclination of an FDC value, on the basis of the FDC value at the time of applying the increase inclination or the decrease inclination and the magnitude of a voltage deviation obtained by subtracting the threshold voltage value from the measurement data, a step of increasing the FDC value with the increase inclination or decreasing the FDC value with the decrease inclination on the basis of the result of comparison between the measurement data and a predetermined threshold voltage value, and a step of setting a diagnostic trouble code (DTC) value corresponding to the FDC value to a first value indicating that the battery pack is abnormal, when the FDC value reaches a predetermined upper limit threshold, and setting the DTC value corresponding to the FDC value to a second value indicating that the battery pack is normal, when the FDC value reaches a predetermined lower limit threshold.

The method may further include a step of selecting one of the increase inclination and the decrease inclination on the basis of whether the voltage deviation exceeds 0 or the voltage deviation is smaller than 0, a step of determining the increase inclination by applying a first target weighting determined by the weighting determining unit to a predetermined increase reference inclination stored in advance, and a step of determining the decrease inclination by applying a second target weighting determined by the weighting determining unit to a predetermined decrease reference inclination stored in advance.

The method may further include a step of determining the target weighting as 1 when the FDC value at the time of applying is equal to or smaller than the lower limit value of a predetermined weighting application range between the upper limit threshold and the lower limit threshold or equal to or larger than the upper limit value of the weighting application range.

The method may further include a step of determining one of a plurality of reference weightings as the target weighting, depending on the magnitude of the voltage deviation, when the FDC value at the time of applying is within a predetermined weighting application range between the upper limit threshold and the lower limit threshold, and the greater the ratio of the voltage deviation to the threshold voltage value is, the larger the values of the plurality of reference weightings may be.

The method may further include a step of determining the FDC value as the upper limit value of a predetermined weighting application range between the upper limit threshold and the lower limit threshold, when the FDC value at the time of applying is within the weighting application range, the voltage deviation exceeds 0, and the ratio of the voltage deviation to the threshold voltage value exceeds a predetermined upper limit increase deviation.

The method may further include a step of determining the FDC value as the lower limit value of a predetermined weighting application range between the upper limit threshold and the lower limit threshold, when the FDC value at the time of applying is within the weighting application range, the voltage deviation is smaller than 0, and the ratio of the voltage deviation to the threshold voltage value exceeds a predetermined upper limit decrease deviation.

### [Advantageous Effects]

According to the present disclosure, a weighting for specific diagnosis using measurement data of a battery may be defined to adjust the intensity on an area which influences a DTC diagnosis enabling condition or diagnosis disabling condition and an area which does not, such that it is possible to quickly reach diagnosis enabling or diagnosis disabling.

According to the present disclosure, the counter step size may be changed depending on the magnitude of the deviation between measurement data and a threshold, such that the more serious the problem occurs in the battery, the faster the diagnosis enabling condition is reached.

According to the present disclosure, it is possible to prevent an excessively long time from being taken for diagnosis disabling after the diagnosis enabling condition occurs, thereby promoting the convenience in the use of a vehicle or the like.

### [Description of the Drawings]

FIG. 1 is a view schematically illustrating a battery system including a battery fault diagnosing device according to an exemplary embodiment.
FIG. 2 is a graph for explaining an unweighted increase inclination.
FIG. 3 is a graph for explaining an unweighted decrease inclination.
FIG. 4 is a view for explaining a weighting application range in the graph shown in FIG. 2.
FIG. 5 is an exemplary view of a weight factor map according to an exemplary embodiment.
FIG. 6 is a graph for explaining, as an example, an operation of determining an FDC value with a weighted inclination according to an exemplary embodiment.
FIG. 7 is a flow chart of a method of determining a weighted FDC value according to an exemplary embodiment.
FIG. 8 is a detailed flow chart of STEP S200 shown in FIG. 7.

### [Mode for Invention]

Hereinafter, exemplary embodiments disclosed in this specification will be described in detail with reference to the accompanying drawings; however, the same or similar constituent components are denoted by the same or similar reference symbols, and a repeated description thereof will not be made. As used herein, the suffix 'module' and/or the suffix 'unit' for constituent elements are given and used interchangeably in consideration of only ease of preparing this specification, and the suffixes themselves do not have meanings or roles distinguishable from each other. Further, when describing exemplary embodiments disclosed in this specification, detailed descriptions of publicly known technologies will be omitted if it is determined that specific description thereof may obscure the gist of the exemplary embodiments disclosed in this specification. Furthermore, the accompanying drawings are provided for helping to easily understand exemplary embodiments disclosed in the present specification, and the technical spirit disclosed in the present specification is not limited by the accompanying drawings, and it will be appreciated that the present invention includes all of the modifications, equivalent matters, and substitutes included in the spirit and the technical scope of the present invention.

Terms including an ordinal number, such as first and second, are used for describing various constituent elements, but the constituent elements are not limited by the terms. The terms are used only to discriminate one constituent element from another constituent element.

When a constituent element is referred to as being "connected" or "coupled" to another constituent element, it will be appreciated that it may be directly connected or coupled to the other constituent element or intervening other constituent elements may be present. In contrast, when a constituent element is referred to as being "directly connected" or "directly coupled" to another constituent element, it will be appreciated that there are no intervening other constituent elements present.

In the present application, it will be appreciated that terms "including" and "having" are intended to designate the existence of characteristics, numbers, steps, operations, constituent elements, and components described in the specification or a combination thereof, and do not exclude a possibility of the existence or addition of one or more other characteristics, numbers, steps, operations, constituent elements, and components, or a combination thereof in advance.

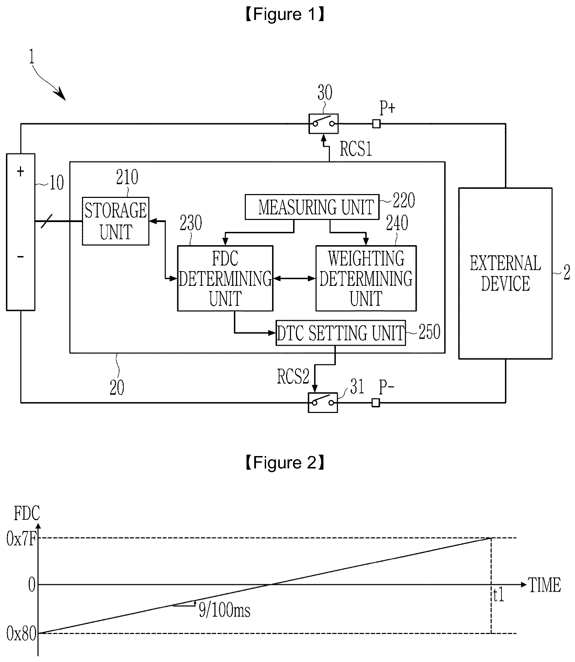

FIG. 1 is a view schematically illustrating a battery system including a battery fault diagnosing device according to an exemplary embodiment.

Referring to FIG. 1, a battery system 1 may include a battery pack 10, a battery fault diagnosing device 20, and relays 30 and 31.

One end of each of the relays 30 and 31 is connected to the battery pack 10, and the other end of each of the relays 30 and 31 is connected to at least one component in an external device 2. Opening and closing of the relays 30 and 31 may be controlled in response to relay control signals RCS1 and RCS2 which are provided from the battery fault diagnosing device 20.

The battery system 1 may be connected to the external device 2. The external device 2 may include loads such as an inverter and a converter, and a charging device. When the external device 2 is a charger, both terminals P+ and P- of the battery system 1 may be connected to the charger and be charged by receiving power from the charger. When the external device 2 is a load, both terminals P+ and P- of the battery system 1 may be connected to the load, and power which is supplied by the battery pack 10 may be released through the load.

The battery pack 10 may be implemented with two or more battery cells connected in series, a plurality of battery cell groups each of which consists of two or more battery cells connected in parallel and which is connected in series, or two or more battery cells connected in parallel.

The battery fault diagnosing device 20 may diagnose a fault of a battery by generating fault detection counter (FDC) information from a lower limit threshold to an upper limit threshold for the battery. The battery fault diagnosing device 20 may set a diagnostic trouble code (DTC) value corresponding to an FDC value. The battery fault diagnosing device 20 may be provided in a battery management system (BMS) of the battery pack 10. When the battery system 1 is connected to a vehicle, the vehicle may transmit a request message for obtaining DTC information to the battery system 1. The request message may be a message for requesting information on a DTC belonging to a specific DTC state and a fault detection counter (FDC) corresponding to the DTC. When receiving the request message, the battery system 1 may transmit a response message corresponding to the request message to the vehicle. The response message may include a DTC value set by the battery system 1.

The battery fault diagnosing device 20 may include a storage unit 210, a measuring unit 220, an FDC determining unit 230, a weighting determining unit 240, and a DTC setting unit 250. The storage unit 210 is a component corresponding to a memory of the battery fault diagnosing device 20, and the FDC determining unit 230, the weighting determining unit 240, and the DTC setting unit 250 may be included in a component corresponding to a processor of the battery fault diagnosing device 20.

The measuring unit 220 may be connected to the battery pack 10 and generate measurement data indicating the state of the battery pack 10. The measuring unit 220 may be electrically connected to the battery pack 10. The state of the battery pack 10 may include at least one of the voltage, current, temperature, and so on of the battery pack 10. The measuring unit 220 may include at least one of a voltage sensor, a current sensor, and a temperature sensor. Here, the voltage sensor may measure the positive terminal voltage and/or negative terminal voltage of the battery pack 10, the cell voltage of each of the plurality of battery cells included in the battery pack 10, etc. The current sensor may measure current flowing in the battery pack 10 while the battery pack 10 performs a charging operation or a discharging operation. The temperature sensor may be provided at a position adjacent to the battery pack 10 and measure the temperature of the battery pack 10. The measurement data may include at least one of the voltage measured by the voltage sensor, the current measured by the current sensor, and the temperature measured by the temperature sensor.

For ease of explanation, the following description will be made on the assumption that the measurement data is the cell voltage of each of the plurality of battery cells included in the battery pack 10.

The FDC determining unit 230 may indicate the FDC value with an increase inclination or decrease the FDC value with a decrease inclination, on the basis of the result of comparison between the measurement data generated by the measuring unit 220 and a predetermined threshold voltage value. Here, the threshold voltage value may be a voltage value for determining whether the cell voltage which is the measurement data is in a normal condition.

When the measurement data indicates a fail condition, the FDC determining unit 230 may include the FDC value with the increase inclination. For example, when the voltage deviation obtained by subtracting the predetermined threshold voltage value from the measurement data exceeds 0, it may be a fail condition. Hereinafter, for ease of explanation, the FDC determining unit 230 will be referred to as increasing the FDC value with the increase inclination when the voltage deviation exceeds 0.

When the measurement data indicates a pass condition, the FDC determining unit 230 may decrease the FDC value with the decrease inclination. For example, when the voltage deviation is smaller than 0, it may be a pass condition. Hereinafter, for ease of explanation, the FDC determining unit 230 will be referred to as decreasing the FDC value with the decrease inclination when the voltage deviation is smaller than 0.

When the FDC value determined by the FDC determining unit 230 reaches a predetermined upper limit threshold, the DTC setting unit 250 may set the DTC value corresponding to the determined FDC value to a first value indicating that the battery pack 10 is abnormal, and when the determined FDC value reaches a predetermined lower limit threshold, the DTC setting unit may set the DTC value corresponding to the determined FDC value to a second value indicating that the battery pack 10 is normal. The first value may indicate that a diagnosis enabling condition (Test Fail) has been reached and diagnosis on the battery pack 10 is required. The second value may indicate that a diagnosis disabling condition (Test Pass) has been reached and the diagnosis on the battery pack 10 which has been enabled may be disabled.

The storage unit 210 may have the predetermined upper limit threshold and the predetermined lower limit threshold stored therein to be compared with the FDC value. For example, the upper limit threshold may be 0x7F (=127), and the lower limit threshold may be 0x80 (=-128).

When the FDC value determined by the FDC determining unit 230 reaches the predetermined upper limit threshold, the DTC setting unit 250 may determine that the battery pack 10 is abnormal, as the result of a fault test on the measurement data. When the FDC value determined by the FDC determining unit 230 reaches the predetermined lower limit threshold, the DTC setting unit 250 may determine that the battery pack 10 is normal, as the result of a fault test on the measurement data. The state where the battery pack 10 is abnormal is the state where the diagnosis enabling condition has been reached, and the state where the battery pack is normal is the state where the diagnosis disabling condition has been reached.

The increase inclination may be the number of steps by which the counter value of the FDC is stepped up (increased) corresponding to a predetermined test period, and the decrease inclination may be the number of steps by which the counter value of the FDC is stepped down (decreased) corresponding to a predetermined test period. For example, the increase inclination and the decrease inclination may be the numbers of steps by which the counter value is increased or decreased for a test period of 100 ms. Accordingly, when the test period 100 ms, the decrease inclination X steps/100 ms, and the voltage deviation value is smaller than 0 for a period from a first time point to a second time point which is 300 ms later than the first time point, the FDC determining unit 230 may determine the FDC value at the second time point by decreasing the FDC value at the first time point by 3X according to the rate of X steps/100 ms for 300 ms.

On the basis of the FDC value and the magnitude of the voltage deviation at a time when the FDC determining unit 230 applies the increase inclination or the decrease inclination, the weighting determining unit 240 may determine a weighting to be applied to the increase inclination and/or the decrease inclination which the FDC determining unit 230 uses. Hereinafter, for ease of explanation, the state where the voltage deviation exceeds 0 may indicate the state where the weighting determining unit 240 may determine a weighting to be applied to the increase inclination and/or the FDC determining unit 230 may increase the FDC value with the increase inclination. Further, for ease of explanation, the state where the voltage deviation is smaller than 0 may indicate the state where the weighting determining unit 240 may determine a weighting to be applied to the decrease inclination and/or the FDC determining unit 230 may decrease the FDC value with the decrease inclination.

When the voltage deviation exceeds 0, the FDC determining unit 230 may select the increase inclination from the increase inclination and the decrease inclination, and determine a value obtained by applying a first target weighting, determined by the weighting determining unit 240, to a predetermined increase reference inclination stored in advance, as the increase inclination.

When the voltage deviation is smaller than 0, the FDC determining unit 230 may select the decrease inclination from the increase inclination and the decrease inclination, and determine a value obtained by applying a second target weighting, determined by the weighting determining unit 240, to a predetermined decrease reference inclination stored in advance, as the decrease inclination.

For example, the increase inclination may be the product of the increase reference inclination and the target weighting, and the decrease inclination may be the product of the predetermined decrease reference inclination stored in advance and the target weighting.

The storage unit 210 may have the predetermined threshold voltage value, the predetermined increase reference inclination, and the predetermined decrease reference inclination stored therein to be compared with the measurement data. The predetermined threshold voltage value may be, for example, 4.0 V. The predetermined increase reference inclination and the predetermined decrease reference inclination may be values different depending on the type of the measurement data (such as voltage, current, temperature, etc.)

For example, the increase reference inclination corresponding to the cell voltage may be 9 steps/100 ms, and the decrease reference inclination corresponding to the cell voltage may be 13 steps/100 ms. Hereinafter, the increase reference inclination and the decrease reference inclination corresponding to the cell voltage will be referred to as conforming to the above-mentioned examples, but this is for ease of explanation, and the present disclosure is not limited thereto. In some exemplary embodiments, each of the increase reference inclination and the decrease reference inclination may be a variable value depending on a diagnostic target, a project, etc. Here, a diagnostic target may be a target indicated by a DTC corresponding to an FDC value which is determined, and a project may be a target which uses a diagnostic target to manage a vehicle.

When the target weighting is 1, the increase inclination may be the increase reference inclination stored in advance, and the decrease inclination may be the decrease reference inclination stored in advance. Hereinafter, for ease of explanation, each (e.g., the increase inclination) of the increase inclination and the decrease inclination which are used by the FDC determining unit 230 will be referred to as being a value obtained by applying the target weighting to the corresponding reference inclination (e.g., the increase reference inclination) of the predetermined increase reference inclination and the predetermined decrease reference inclination stored in advance. Accordingly, hereinafter, the case where the weighting determining unit 240 determines the target weighting as 1 may indicate the case where the increase inclination or the decrease inclination is not weighted.

FIG. 2 is a graph for explaining an unweighted increase inclination.

Referring to FIG. 2, when the increase reference inclination corresponding to the cell voltage is 9 steps/100 ms and the increase inclination is unweighted, the FDC value may increase by 9 every 100 ms. In FIG. 2, the lower limit threshold of the FDC will be referred to as being 0x80, and the upper limit threshold of the FDC will be referred to as being 0x7F.

When the voltage deviation exceeds during a fault test period, the FDC determining unit 230 may increase the FDC value from the lower limit threshold (0x80) of the FDC with the increase inclination. When the FDC value reaches the upper limit threshold (0x7F) of the FDC, the DTC setting unit 250 may set the DTC value to the first value at the time point t1 when the FDC value reaches the upper limit threshold (0x7F) of the FDC.

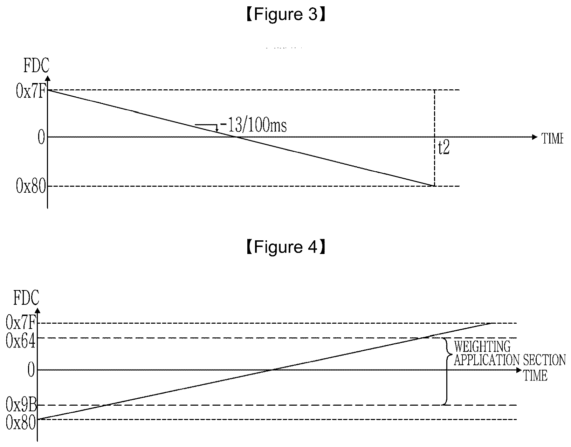

FIG. 3 is a graph for explaining an unweighted decrease inclination.

Referring to FIG. 3, when the decrease reference inclination corresponding to the cell voltage is 13 steps/100 ms and the decrease inclination is unweighted, the FDC value may decrease by 13 every 100 ms. In FIG. 3, the lower limit threshold of the FDC will be referred to as being 0x80, and the upper limit threshold of the FDC will be referred to as being 0x7F.

When the voltage deviation is smaller than 0 for a fault test period, the FDC determining unit 230 may decrease the FDC value from the upper limit threshold (0x75F) with the decrease inclination of 13 steps/100 ms. When the FDC value reaches the lower limit threshold (0x80) of the FDC, the DTC setting unit 250 may set the DTC value to the second value at the time point t2 when the FDC value reaches the lower limit threshold (0x80) of the FDC.

Hereinafter, the operation of the FDC determining unit 230 to determine the FDC value on the basis of the increase inclination or decrease inclination to which the weighting determined by the weighting determining unit 240 has been applied in the exemplary embodiment will be described.

When the FDC value at a time when the increase inclination or the decrease inclination is applied is within a predetermined weighting application range (hereinafter, referred to as the "weighting application range") between the upper limit threshold of the FDC and the lower limit threshold of the FDC, the weighting determining unit 240 may determine a target weighting equal to or larger than 1, and when the corresponding FDC value is out of the weighting application range, the weighting determining unit may determine the target weighting as 1. Here, the weighting application range may be a range indicating the normal condition between the upper limit threshold of the FDC and the lower limit threshold of the FDC. The lower limit value of the weighting application range may be a value larger than the above-described lower limit threshold of the FDC, and the upper limit value of the weighting application range may be a value smaller than the above-described upper limit threshold of the FDC. For example, the lower limit value of the weighting application range may be 0x9B, and the upper limit value of the weighting application range may be 0x64.

Specifically, when the FDC value at a time when the increase inclination or the decrease inclination is applied is equal to or smaller than the lower limit value of the weighting application range, or equal to or larger than the upper limit value of the weighting application range, the weighting determining unit 240 may determine the target weighting as 1.

However, this is merely for ease of explanation, and the present disclosure is not limited thereto. In some exemplary embodiments, when the voltage deviation is smaller than 0 and the FDC value at the time when the decrease inclination is applied is equal to or smaller than the lower limit value of the weighting application range, or when the voltage deviation exceeds 0 and the FDC value at the time when the increase inclination is applied is equal to or larger than the upper limit value of the weighting application range, the weighting determining unit 240 may determine the target weighting as 1. In other words, in the case of increasing the FDC value even though the FDC value at the time when the increase inclination or the decrease inclination is applied is equal to or smaller than the lower limit value of the weighting application range, or in the case of decreasing the FDC value even though the FDC value at the time when the increase inclination or the decrease inclination is applied is equal to or larger than the upper limit value of the weighting application range, the weighting determining unit 240 may determine that the FDC value is within the weighting application range.

Hereinafter, an operation of the weighting determining unit 240 to determining a target weighting by comparing the FDC value at the time when the increase inclination or the decrease inclination is applied with the weighting application range will be referred to as a "first weighting determining operation".

FIG. 4 is a view for explaining a weighting application range in the graph shown in FIG. 2.

Referring to FIG. 4, between the lower limit threshold (0x80) and upper limit threshold (0x7F) of the FDC, a range between 0x9B and 0x64 may be used as the weighting application range.

For example, when the FDC value at the first time point is a value between the lower limit threshold (0x80) of the FDC and the lower limit value (0x9B) of the weighting application range, the weighting determining unit 240 may determine the target weighting as 1 from the first time point to the second time point after the first time point. Accordingly, when the voltage deviation corresponding to the period from the first time point to the second time point is smaller than 0, the FDC determining unit 230 may determine the decrease inclination from the first time point to the second time point, as the decrease reference inclination.

Further, when the FDC value at a third time point is a value between the upper limit threshold (0x7F) of the FDC and the upper limit value (0x64) of the weighting application range, the weighting determining unit 240 may determine the target weighting as 1 from the third time point to a fourth time point after the third time point. Accordingly, when the voltage deviation corresponding to the period from the third time point to the fourth time point after the third time point exceeds 0, the FDC determining unit 230 may determine the increase inclination from the third time point to the fourth time point, as the increase reference inclination.

When the FDC value at the time when the increase inclination or the decrease inclination is applied is within the weighting application range, the weighting determining unit 240 may determine the value of the target weighting depending on the magnitude of the voltage deviation.

Hereinafter, an operation of the weighting determining unit 240 to determine the value of the target weighting depending on the magnitude of the voltage deviation will be referred to as a "second weighting determining operation". Hereinafter, a process in which the weighting determining unit 240 determines the value of the target weighting depending on the magnitude of the voltage deviation will be described.

The storage unit 210 may have a weight factor map, including a plurality of reference weightings corresponding to a plurality of threshold deviation sections, stored therein. The weight factor map may include a plurality of increase reference weightings corresponding to a plurality of increase threshold deviation sections and a plurality of decrease reference inclinations corresponding to a plurality of decrease threshold deviation sections. When the FDC determining unit 230 selects to apply the increase inclination of the increase inclination and the decrease inclination, the weighting determining unit 240 may determine one of the plurality of increase reference weightings corresponding to the plurality of increase threshold deviation sections, as the target weighting. Further, when the FDC determining unit 230 selects to apply the decrease inclination of the increase inclination and the decrease inclination, the weighting determining unit 240 may determine one of the plurality of decrease reference inclinations corresponding to the plurality of decrease threshold deviation sections, as the target weighting. Hereinafter, the plurality of threshold deviation sections may indicate a plurality of corresponding threshold deviation sections of the plurality of increase threshold deviation sections and the plurality of decrease threshold deviation sections, and the plurality of reference weightings may indicate a plurality of corresponding reference weightings of the plurality of increase reference weightings and the plurality of decrease reference inclinations.

The weighting determining unit 240 may determine a reference weighting corresponding to a threshold deviation section to which the ratio of the voltage device to the threshold voltage value belongs among the plurality of threshold deviation sections, as the target weighting. Here, the larger the threshold deviations which are indicated by the plurality of individual threshold deviation sections, the larger the plurality of reference weightings. The ratio of the voltage deviation to the threshold voltage value may be a value obtained by dividing the absolute value of the voltage deviation by the threshold voltage value.

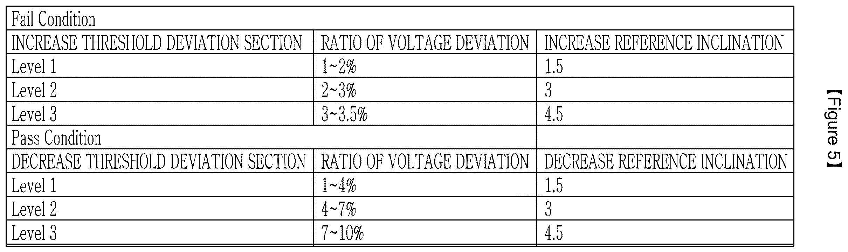

FIG. 5 is an exemplary view of a weight factor map according to an exemplary embodiment.

Referring to FIG. 5, a plurality of increase threshold deviation sections corresponding to the fail condition may include sections such as Level 1 at which the ratio of the voltage deviation is equal to or larger than 1% and smaller than 2%, Level 2 at which the ratio of voltage deviation is equal to or larger than 2% and smaller than 3%, Level 3 at which the ratio of voltage deviation is equal to or larger than 3% and equal to or smaller than 3.5%, etc. In this case, among the plurality of increase reference weightings, the increase reference weighting corresponding to the increase threshold deviation section in which the ratio of the voltage deviation is equal to or larger than 1% and smaller than 2% may be 1.5, the increase reference weighting corresponding to the increase threshold deviation section in which the ratio of voltage deviation is equal to or larger than 2% and smaller than 3% may be 3, and the increase reference weighting corresponding to the increase threshold deviation section in which the ratio of voltage deviation is equal to or larger than 3% and equal to or smaller than 3.5% may be 4.5. The target weighting corresponding to the voltage deviation of less than 1% which does not belong to the plurality of increase threshold deviation sections may be 1.

Referring to FIG. 5, a plurality of decrease threshold deviation sections corresponding to the pass condition may include sections such as Level 1 at which the ratio of voltage deviation is equal to or larger than 1% and smaller than 4%, Level 2 at which the ratio of voltage deviation is equal to or larger than 4% and smaller than 7%, Level 3 at which the ratio of voltage deviation is equal to or larger than 7% and equal to or smaller than 10%, etc. In this case, among a plurality of decrease reference weightings, the decrease reference weighting corresponding to the decrease threshold deviation section in which the ratio of voltage deviation is equal to or larger than 1% and smaller than 4% may be 1.5, the decrease reference weighting corresponding to the decrease threshold deviation section in which the ratio of voltage deviation is equal to or larger than 4% and smaller than 7% may be 3, and the decrease reference weighting corresponding to the decrease threshold deviation section in which the ratio of voltage deviation is equal to or larger than 7% and equal to or smaller than 10% may be 4.5. The target weighting corresponding to the voltage deviation of less than 1% which does not belong to the plurality of decrease threshold deviation sections may be 1.

Hereinafter, the plurality of increase reference weightings corresponding to the plurality of increase threshold deviation sections and the plurality of decrease reference weightings corresponding to the plurality of decrease threshold deviation sections will be referred to as conforming to the example of FIG. 5, but this is for ease of explanation, and the present disclosure is not limited thereto

In some exemplary embodiments, the number of the plurality of increase threshold deviation sections, the number of the plurality of decrease threshold deviation sections, the values of the threshold deviations which are indicated by the plurality of increase threshold deviation sections and the plurality of decrease threshold deviation sections, respectively, and the value of each of the plurality of increase reference weightings and the plurality of decrease reference weightings may be variable values depending on a diagnostic target, a project, etc.

This is for making it possible to apply a larger target weighting for a larger voltage deviation value within the predetermined weighting application range in order to reach the diagnosis enabling condition or the diagnosis disabling condition faster than increasing or decreasing the FDC value with a constant increase or decrease inclination.

However, in the case where the voltage deviation value is significantly large, the diagnosis enabling condition or the diagnosis disabling condition may be directly reached without an additional FDC counting operation, or an FDC value close to the diagnosis enabling condition or the diagnosis disabling condition may be reached, thereby coping with the large voltage deviation of the battery pack 10.

When the voltage deviation exceeds 0 and the ratio of voltage deviation to the threshold voltage value exceeds a predetermined upper limit increase deviation, the FDC determining unit 230 may determine the FDC value as the upper limit threshold of the FDC. For example, when the voltage deviation exceeds 0 and exceeds 3.5% of the threshold voltage value, the FDC determining unit 230 may immediately increase the FDC value to the upper limit threshold (0x7F). In this case, since the FDC value reaches the upper limit threshold, the DTC setting unit 250 may set the DTC value corresponding to the FDC value to the first value indicating that the battery pack 10 is abnormal.

When the voltage deviation is smaller than 0 and the ratio of voltage deviation to the threshold voltage value exceeds a predetermined upper limit decrease deviation, the FDC determining unit 230 may determine the FDC value as the lower limit threshold of the FDC. For example, when the voltage deviation is smaller than 0 and exceeds 10% of the threshold voltage value, the FDC determining unit 230 may immediately decrease the FDC value to the lower limit threshold (0x80). In this case, since the FDC value reaches to the lower limit threshold, the DTC setting unit 250 may set the DTC value corresponding to the FDC value to the second value indicating that the battery pack 10 is normal.

Hereinafter, an upper limit deviation may indicate a corresponding upper limit deviation of the upper limit increase deviation and the upper limit decrease deviation.

However, the exemplary embodiment described above with respect to the case where the voltage deviation value is significantly large and thus the voltage deviation exceeds the upper limit deviation is merely an example, and the present disclosure is not limited thereto. In some exemplary embodiments, when the voltage deviation exceeds the upper limit deviation, the FDC determining unit 230 may determine the FDC value as the upper limit value or lower limit value of the weighting application range. For example, when the voltage deviation exceeds 0 and the ratio of voltage deviation to the threshold voltage value exceeds the predetermined upper limit increase deviation, the FDC determining unit 230 may determine the FDC value as the upper limit value of the weighting application range. Further, for example, when the voltage deviation is smaller than 0 and the ratio of voltage deviation to the threshold voltage value exceeds the predetermined upper limit decrease deviation, the FDC determining unit 230 may determine the FDC value as the lower limit value of the weighting application range.

Hereinafter, an operation of the FDC determining unit 230 to determine the FDC value depending on whether the voltage deviation exceeds the upper limit deviation will be referred to as a "third weighting determining operation".

The above-mentioned first to third weighting determining operations may be sequentially performed. For example, when the FDC value at the time of applying the increase inclination or the decrease inclination is out of the weighting application range, even if the ratio of voltage deviation exceeds the predetermined upper limit increase deviation or the predetermined upper limit decrease deviation, the weighting determining unit 240 may determine the value of the target weighting as 1. However, the exemplary embodiment is not limited thereto, and in some exemplary embodiments, if the ratio of voltage deviation exceeds the predetermined lower limit increase deviation or the predetermined upper limit decrease deviation (e.g., the upper limit increase deviation), even though the FDC value at the time of applying the increase inclination or the decrease inclination (e.g., the increase inclination) is within the weighting application range, the FDC determining unit 230 may determine the FDC value as a corresponding value of the upper limit value and lower limit value of the weighting application range (e.g., the upper limit value).

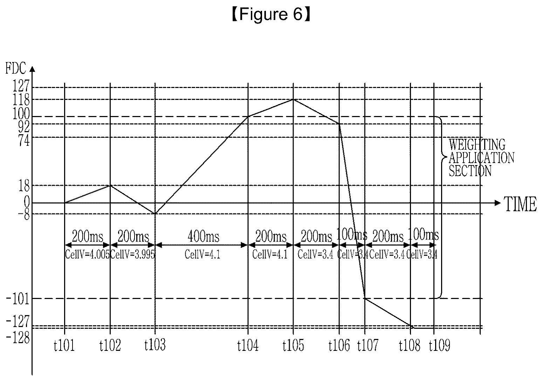

FIG. 6 is a graph for explaining, as an example, an operation of determining an FDC value with a weighted inclination according to an exemplary embodiment.

For ease of explanation, in FIG. 6, the FDC value is shown in decimal. It is assumed that the FDC value at a time point t101 when a fault test is started is 0 indicating the normal condition. In FIG. 6, it is assumed that the upper limit threshold of the FDC is 127, the lower limit threshold of the FDC is -128, the weighting application range is a range from -101 to 100, and the threshold voltage value is 4 V.

Hereinafter, the example of FIG. 6 will be described under the following assumptions. The increase reference inclination corresponding to the cell voltage is 9 steps/100 ms, and the decrease reference inclination corresponding to the cell voltage is 13 steps/100 ms. The plurality of increase reference weightings corresponding to the plurality of increase threshold deviation sections, and the plurality of decrease reference weightings corresponding to the plurality of decrease threshold deviation sections conform to the example of FIG. 5. The target weighting corresponding to the voltage deviation of less than 1% which does not belong to the plurality of increase threshold deviation sections is 1. When the voltage deviation exceeds 0 and the ratio of voltage deviation to the threshold voltage value exceeds 3.5%, the FDC determining unit 230 determines the FDC value as the upper limit value of the weighting application range. The target weighting corresponding to the voltage deviation of less than 1% which does not belong to the plurality of decrease threshold deviation sections is 1. When the voltage deviation is smaller than 0 and the ratio of voltage deviation to the threshold voltage value exceeds 10%, the FDC determining unit 230 determines the FDC value as the lower limit value of the weighting application range.

The period from the time point t101 to a time point t102 is 200 ms, and the cell voltage which is the measurement data from the time point t101 to the time point t102 is 4.005 V. The voltage deviation from the time point t101 to the time point t102 is 0.005 (=4.005-4), and the ratio of voltage deviation to the threshold voltage value is 0.125 (=0.005/4)%. Since the threshold deviation exceeds 0, the FDC value at the time point t101 is smaller than the upper limit value of the weighting application range, and the ratio of voltage deviation to the threshold voltage value is smaller than 1%, the corresponding target weighting is 1. The weighting determining unit 240 may determine the target weighting as 1 from the time point t101 to the time point t102, and the FDC determining unit 230 may apply an increase inclination which is the product of the increase reference inclination from the time point t101 to the time point t102 and the target weighting. Accordingly, the FDC value at the time point t102 may be 18 (=0+9(steps/100ms)*1*200(ms)).

The period from the time point t102 to a time point t103 is 200 ms, and the cell voltage which is the measurement data from the time point t102 to the time point t103 is 3.995 V. The voltage deviation from the time point t102 to the time point t103 is -0.005 (=3.995-4), and the ratio of voltage deviation to the threshold voltage value is 0.125 (=1-0.0051/4)%. Since the threshold deviation is smaller than 0, the FDC value at the time point t102 exceeds the lower limit value of the weighting application range, and the ratio of voltage deviation to the threshold voltage value is smaller than 1%, the corresponding target weighting is 1. The weighting determining unit 240 may determine the target weighting as 1 from the time point t102 to the time point t103, and the FDC determining unit 230 may apply a decrease inclination which is the product of the decrease reference inclination from the time point t102 to the time point t103 and the target weighting. Accordingly, the FDC value at the time point t103 may be -8 (=18-13(steps/100ms)*1*200(ms)).

The period from the time point t103 to a time point t104 is 400 ms, and the cell voltage which is the measurement data from the time point t103 to the time point t104 is 4.1 V. The voltage deviation from the time point t103 to the time point t104 is 0.1 (=4.1-4), and the ratio of voltage deviation to the threshold voltage value is 2.5 (=|0.1|/4)%. Since the FDC value at the time point t103 is smaller than the upper limit value of the weighting application range, the threshold deviation exceeds 0, and the ratio of voltage deviation to the threshold voltage value is equal to or larger than 2% and smaller than 3%, the corresponding target weighting is 3. The weighting determining unit 240 may determine 3 as the target weighting from the time point t103 to the time point t104, and the FDC determining unit 230 may apply an increase inclination which is the product of the increase reference inclination from the time point t103 to the time point t104 and the target weighting. Accordingly, the FDC value at the time point t104 may be 100 (=-8+9(steps/100ms)*3*400(ms)).

The period from the time point t104 to a time point t105 is 200 ms, and the cell voltage which is the measurement data from the time point t104 to the time point t105 is 4.1 V. The voltage deviation from the time point t104 to the time point t105 is 0.1 (=4.1-4), and the ratio of voltage deviation to the threshold voltage value is 2.5 (=|0.1|/4)%. Since the FDC value at the time point t104 is equal to or larger than the upper limit value of the weighting application range, the corresponding target weighting is 1. The weighting determining unit 240 may determine the target weighting as 1 from the time point t104 to the time point t105, and the FDC determining unit 230 may apply an increase inclination which is the product of the increase reference inclination from the time point t104 to the time point t105 and the target weighting. Accordingly, the FDC value at the time point t105 may be 118 (=100+9(steps/100ms)*1*200(ms)).

The period from the time point t105 to a time point t106 is 200 ms, and the cell voltage which is the measurement data from the time point t105 to the time point t106 is 3.4 V. The voltage deviation from the time point t105 to the time point t106 is -0.6 (=3.4-4), and the ratio of voltage deviation to the threshold voltage value is 15 (=|-0.6|/4=15)%. Since the FDC value at the time point t105 is equal to or larger than the upper limit value of the weighting application range, the corresponding target weighting is 1. The weighting determining unit 240 may determine the target weighting as 1 from the time point t105 to the time point t106, and the FDC determining unit 230 may apply a decrease inclination which is the product of the decrease reference inclination from the time point t105 to the time point t106 and the target weighting. Accordingly, the FDC value at the time point t106 may be 92 (=118-13(steps/100ms)*1*200(ms)).

The period from the time point t106 to a time point t107 is 100 ms, and the cell voltage which is the measurement data from the time point t106 to the time point t107 is 3.4 V. The voltage deviation from the time point t106 to the time point t107 is -0.6 (=3.4-4), and the ratio of voltage deviation to the threshold voltage value is 15 (=|-0.6|/4)%. Since the FDC value at the time point t106 is smaller than the upper limit value of the weighting application range, the threshold deviation is smaller than 0, and the ratio of voltage deviation to the threshold voltage value exceeds 10%, the FDC determining unit 230 may determine -101 as the FDC value at the time point t107.

The period from the time point t107 to a time point t108 is 200 ms, and the cell voltage which is the measurement data from the time point t107 to the time point t108 is 3.4 V. The voltage deviation from the time point t107 to the time point t108 is -0.6 (=3.4-4), and the ratio of voltage deviation to the threshold voltage value is 15 (=|-0.6|/4)%. Since the FDC value at the time point t107 is equal to or smaller than the lower limit value of the weighting application range, the corresponding target weighting is 1. The weighting determining unit 240 may determine the target weighting as 1 from the time point t107 to the time point t108, and the FDC determining unit 230 may apply a decrease inclination which is the product of the decrease reference inclination from the time point t107 to the time point t108 and the target weighting. Accordingly, the FDC value at the time point t108 may be -127 (=-101-13(steps/100ms)*1*200(ms)).

The period from the time point t108 to a time point t109 is 100 ms, and the cell voltage which is the measurement data from the time point t108 to the time point t109 is 3.4 V. The voltage deviation from the time point t108 to the time point t109 is -0.6 (=3.4-4), and the ratio of voltage deviation to the threshold voltage value is 15 (=|-0.6|/4=15)%. Since the FDC value at the time point t108 is equal to or smaller than the lower limit value of the weighting application range, the corresponding target weighting is 1. The weighting determining unit 240 may determine the target weighting as 1 from the time point t108 to the time point t109, and the FDC determining unit 230 may apply a decrease inclination which is the product of the decrease reference inclination from the time point t108 to the time point t109 and the target weighting. Accordingly, the FDC value at the time point t108 may be -140 (=-127-13(steps/100ms)*1*100(ms)). By the way, since the lower limit threshold of the FDC is -128, the FDC value may reach the lower limit threshold at a time point between the time point t107 and the time point t108, and the FDC determining unit 230 may determine -128 as the FDC value at the time point t108.

Referring to FIG. 6, since the FDC value reaches the lower limit threshold at a time point between the time point t107 and the time point t108, in response to the time point when the lower limit threshold is reached, the DTC setting unit 250 may set the DTC value of the cell voltage corresponding to the FDC value to the second value indicating that the battery pack 10 is normal.

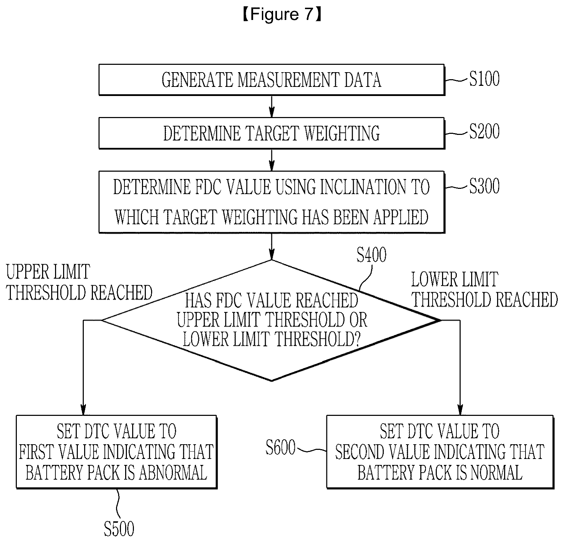

FIG. 7 is a flow chart of a method of determining a weighted FDC value according to an exemplary embodiment.

Hereinafter, the individual components of the battery system 1 will be described, and a redundant description of parts identical to those described above will not be made.

Referring to FIG. 7, the battery fault diagnosing device 20 may generate the measurement data indicating the cell voltage and so on of each of the plurality of battery cells included in the battery pack 10 (S100).

The battery fault diagnosing device 20 may determine the weighting to be applied to the increase inclination or the decrease inclination of the FDC value on the basis of the FDC value at the time of applying the increase inclination or the decrease inclination and the magnitude of the voltage deviation (S200).

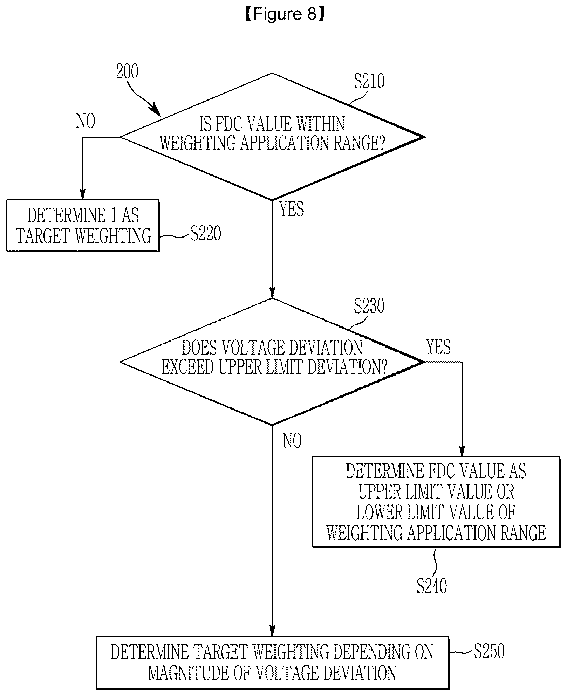

FIG. 8 is a detailed flow chart of STEP S200 shown in FIG. 7.

Referring to FIG. 8, in the battery fault diagnosing device 20, the FDC determining unit 230 may determine whether the FDC value at the time of applying the increase inclination or the decrease inclination is within the weighting application range (S210).

When it is determined in STEP S210 that the FDC value at the time of applying the increase inclination or the decrease inclination is out of the weighting application range ("NO" in STEP S210), the battery fault diagnosing device 20 may determine the target weighting as 1 (S220).

When it is determined in STEP S210 that the FDC value at the time of applying the increase inclination or the decrease inclination is within the weighting application range ("YES" in STEP S210), the battery fault diagnosing device 20 may determine whether the voltage deviation exceeds the upper limit deviation (S230).

When it is determined in STEP S230 that the voltage deviation exceeds the upper limit deviation ("YES" in STEP S230), the battery fault diagnosing device 20 may determine the FDC value as the upper limit value or lower limit value of the weighting application range (S240). When the voltage deviation exceeding 0 exceeds the upper limit increase deviation, the battery fault diagnosing device 20 may determine the FDC value as the upper limit value of the weighting application range. Or, in this case, the battery fault diagnosing device 20 may determine the FDC value as the upper limit threshold of the FDC. When the voltage deviation smaller than 0 exceeds the upper limit decrease deviation, the battery fault diagnosing device 20 may determine the FDC value as the lower limit value of the weighting application range. Or, in this case, the battery fault diagnosing device 20 may determine the FDC value as the lower limit threshold of the FDC.

When it is determined in STEP S230 that the voltage deviation does not exceed the upper limit deviation ("NO" in STEP S230), the battery fault diagnosing device 20 may determine the target weighting depending on the magnitude of the voltage deviation (S250). Specifically, the battery fault diagnosing device 20 may determine the reference weighting corresponding to the ratio of voltage deviation to the threshold voltage value among the plurality of reference weightings included in the weight factor map, as the target weighting.

Referring to FIG. 7 again, the battery fault diagnosing device 20 may determine the FDC value by increasing or decreasing the FDC value with the inclination to which the target weighting has been applied (S300).

If STEP S240 of FIG. 8 among STEPS S210 to S240 shown in FIG. 8 is performed in STEP S200, STEP S400 may be performed without performing STEP S300 of FIG. 7. This is because STEP S240 of FIG. 8 is a step of determining the FDC value regardless of the value of the target weighting.

Referring to FIG. 7, the battery fault diagnosing device 20 may determine whether the FDC value has reached the upper limit threshold or the lower limit threshold (S400).

When it is determined in STEP S400 that the FDC value has reached the upper limit threshold ("UPPER LIMIT THRESHOLD REACHED" in STEP S400), the battery fault diagnosing device 20 may set the DTC value of the cell voltage corresponding to the FDC value to the first value indicating that the battery pack 10 is abnormal (S500).

When it is determined in STEP S400 that the FDC value has reached the lower limit threshold ("LOWER LIMIT THRESHOLD REACHED" in STEP S400), the battery fault diagnosing device 20 may set the DTC value of the cell voltage corresponding to the FDC value to the second value indicating that the battery pack 10 is normal (S600).

While this invention has been described in connection with what is presently considered to be practical exemplary embodiments, it is to be understood that the invention is not limited to the disclosed embodiments. On the contrary, it is intended to cover various modifications and equivalent arrangements included within the spirit and scope of the appended claims.

## Claims

1. A battery fault diagnosis device for diagnosing a fault of a battery by generating fault detection counter (FDC) information from a lower limit threshold to an upper limit threshold for the battery, the device comprising:
a measuring unit that is connected to a battery pack and generates measurement data on the cell voltage of each of a plurality of battery cells included in the battery pack;
an FDC determining unit that increases an FDC value with an increase inclination or decreases the FDC value with a decrease inclination on the basis of the result of comparison between the measurement data and a predetermined threshold voltage value;
a weighting determining unit that determines a target weighting to be applied to the increase inclination or the decrease inclination, on the basis of the FDC value at the time of applying the increase inclination or the decrease inclination and the magnitude of a voltage deviation obtained by subtracting the threshold voltage value from the measurement data; and
a diagnostic trouble code (DTC) setting unit that sets a diagnostic trouble code (DTC) value corresponding to the FDC value to a first value indicating that the battery pack is abnormal, when the FDC value reaches a predetermined upper limit threshold, and sets the DTC value corresponding to the FDC value to a second value indicating that the battery pack is normal, when the FDC value reaches a predetermined lower limit threshold.

2. The battery fault diagnosing device of claim 1, wherein:
the FDC determining unit performs the following:
when the voltage deviation exceeds 0, selecting the increase inclination from the increase inclination and the decrease inclination, and determining a value obtained by applying a first target weighting determined by the weighting determining unit to a predetermined increase reference inclination stored in advance, as the increase inclination; and
when the voltage deviation is smaller than 0, selecting the decrease inclination from the increase inclination and the decrease inclination, and determining a value obtained by applying a second target weighting determined by the weighting determining unit to a predetermined decrease reference inclination stored in advance, as the decrease inclination.

3. The battery fault diagnosing device of claim 1, wherein:
when the FDC value at the time of applying is equal to or smaller than the lower limit value of a predetermined weighting application range between the upper limit threshold and the lower limit threshold, or equal to or larger than the upper limit value of the weighting application range,
the weighting determining unit determines the target weighting as 1.

4. The battery fault diagnosing device of claim 1, wherein:
when the FDC value at the time of applying is within a predetermined weighting application range between the upper limit threshold and the lower limit threshold,
the weighting determining unit determines one of a plurality of reference weightings as the target weighting, depending on the magnitude of the voltage deviation, and
the greater the ratio of the voltage deviation to the threshold voltage value is, the larger the values of the plurality of reference weightings is.

5. The battery fault diagnosing device of claim 1, wherein:
when the FDC value at the time of applying is within a predetermined weighting application range between the upper limit threshold and the lower limit threshold, the voltage deviation exceeds 0, and the ratio of the voltage deviation to the threshold voltage value exceeds a predetermined upper limit increase deviation,
the FDC determining unit determines the FDC value as the upper limit value of the weighting application range.

6. The battery fault diagnosing device of claim 1, wherein:
when the FDC value at the time of applying is within a predetermined weighting application range between the upper limit threshold and the lower limit threshold, the voltage deviation is smaller than 0, and the ratio of the voltage deviation to the threshold voltage value exceeds a predetermined upper limit decrease deviation,
the FDC determining unit determines the FDC value as the lower limit value of the weighting application range.

7. A method by which a device for diagnosing a fault of a battery by generating fault detection counter (FDC) information from a lower limit threshold to an upper limit threshold for the battery determines an FDC value by applying a weighting, the method comprising:
a step of generating measurement data indicating the cell voltage of each of a plurality of battery cells included in a battery pack;
a step of determining a target weighting to be applied to an increase inclination or a decrease inclination of an FDC value, on the basis of the FDC value at the time of applying the increase inclination or the decrease inclination and the magnitude of a voltage deviation obtained by subtracting the threshold voltage value from the measurement data;
a step of increasing the FDC value with the increase inclination or decreasing the FDC value with the decrease inclination on the basis of the result of comparison between the measurement data and a predetermined threshold voltage value; and
a step of setting a diagnostic trouble code (DTC) value corresponding to the FDC value to a first value indicating that the battery pack is abnormal, when the FDC value reaches a predetermined upper limit threshold, and setting the DTC value corresponding to the FDC value to a second value indicating that the battery pack is normal, when the FDC value reaches a predetermined lower limit threshold.

8. The method of claim 7, further comprising:
a step of selecting one of the increase inclination and the decrease inclination on the basis of whether the voltage deviation exceeds 0 or the voltage deviation is smaller than 0;
a step of determining the increase inclination by applying a first target weighting determined by the weighting determining unit to a predetermined increase reference inclination stored in advance; and
a step of determining the decrease inclination by applying a second target weighting determined by the weighting determining unit to a predetermined decrease reference inclination stored in advance.

9. The method of claim 7, further comprising:
a step of determining the target weighting as 1 when the FDC value at the time of applying is equal to or smaller than the lower limit value of a predetermined weighting application range between the upper limit threshold and the lower limit threshold or equal to or larger than the upper limit value of the weighting application range.

10. The method of claim 7, further comprising:
a step of determining one of a plurality of reference weightings as the target weighting, depending on the magnitude of the voltage deviation, when the FDC value at the time of applying is within a predetermined weighting application range between the upper limit threshold and the lower limit threshold,
wherein the greater the ratio of the voltage deviation to the threshold voltage value is, the larger the values of the plurality of reference weightings is.

11. The method of claim 7, further comprising:
when the FDC value at the time of applying is within a predetermined weighting application range between the upper limit threshold and the lower limit threshold, the voltage deviation exceeds 0, and the ratio of the voltage deviation to the threshold voltage value exceeds a predetermined upper limit increase deviation, a step of determining the FDC value as the upper limit value of the weighting application range.

12. The method of claim 7, further comprising:
when the FDC value at the time of applying is within a predetermined weighting application range between the upper limit threshold and the lower limit threshold, the voltage deviation is smaller than 0, and the ratio of the voltage deviation to the threshold voltage value exceeds a predetermined upper limit decrease deviation, a step of determining the FDC value as the lower limit value of the weighting application range.
